Europäisches Patentamt

European Patent Office

Office européen des brevets

(19)

(11) Veröffentlichungsnummer: **0 130 615**
A2

# (12) EUROPÄISCHE PATENTANMELDUNG

(21) Anmeldenummer: **84107738.1**

(22) Anmeldetag: **04.07.84**

(51) Int. Cl.⁴: **H 05 K 3/02,** G 03 F 7/10

(30) Priorität: **05.07.83 DE 3324117**

(43) Veröffentlichungstag der Anmeldung: **09.01.85**
**Patentblatt 85/2**

(84) Benannte Vertragsstaaten: **BE CH FR GB IT LI NL SE**

(71) Anmelder: **Gebr. Schmid GmbH & Co.,**
**Robert-Bosch-Strasse 34, D-7290 Freudenstadt (DE)**

(72) Erfinder: **Schmid, Dieter C., Dipl.-Ing., Am**
**Schäferstich 19, D-7290 Freudenstadt (DE)**

(74) Vertreter: **Hoeger, Stellrecht & Partner,**
**Uhlandstrasse 14c, D-7000 Stuttgart 1 (DE)**

(54) Verfahren und Herstellung gedruckter Schaltungen und Photolack zur Durchführung dieses Verfahrens.

(57) Um bei einem Verfahren zur Herstellung von gedruckten Schaltungen, bei welchem man auf einen Träger Substanzen aufbringt, die sich durch elektromagnetische Strahlung so verändern, dass bestrahlte Gebiete nach der Bestrahlung chemisch entfernbar sind, während unbestrahlte Gebiete auf dem Träger verbleiben oder umgekehrt, die Herstellung zu vereinfachen und eine weitergehende Miniaturisierung zu ermöglichen, wird vorgeschlagen, dass man den strahlungsempfindlichen Substanzen elektrisch leitende Partikel oder elektrisch leitende Salze zugibt, so dass die nach der chemischen Entfernung auf dem Träger verbleibenden Gebiete elektrisch leitend sind. Ferner wird ein Photopolymer zur Durchführung dieses Verfahrens vorgeschlagen.

ACTORUM AG

A 45 556 u  
u - 183  
3. Mai 1983

Anmelderin: Firma  
Gebr. Schmid GmbH & Co.

7290 Freudenstadt

B e s c h r e i b u n g

Verfahren und Herstellung  
gedruckter Schaltungen und  
Photolack zur Durchführung  
dieses Verfahrens

Die Erfindung betrifft ein Verfahren zur Herstellung gedruckter Schaltungen, bei welchem man auf einen Träger Substanzen aufbringt, die sich durch elektromagnetische Strahlung so verändern, daß bestrahlte Gebiete nach der Bestrahlung chemisch entfernbar sind, während unbestrahlte Gebiete auf dem Träger verbleiben, oder umgekehrt.

Die Erfindung betrifft weiterhin einen Photopolymer zur Herstellung gedruckter Schaltungen.

Bei der Herstellung von gedruckten Schaltungen ist die Verwendung sogenannter "Photolacke" bekannt, d.h. die Verwendung von Substanzen, die unter elektromagnetischer Bestrah

lung sich so umsetzen, daß sie nach der Bestrahlung gegenüber bestimmten Chemikalien sich anders verhalten als nicht bestrahlte Bereiche. Es ist dadurch möglich, durch geeignete Verfahren, beispielsweise durch Entwickeln, bestrahlte oder bei anderen Substanzen auch nicht bestrahlte Gebiete von einem Träger zu entfernen, während nicht bestrahlte bzw. bestrahlte Gebiete auf dem Träger verbleiben. Diese Technik wird bei bekannten Leiterplatten dazu verwendet, bestimmte Gebiete auf der Leiterplatte abzudecken und andere bestimmte Gebiete freizulegen. Dabei kann die nach dem Entwickeln auf der Leiterplatte verbleibende Substanz als sogenannte Ätzreserve dienen, d.h. eine von ihr abgedeckte Kupferschicht bleibt beim Ätzen erhalten, während in den nicht abgedeckten Gebieten das Kupfer von der Leiterplatte weggeätzt wird. Die verbleibenden Bereiche können auch als sogenannter Galvanoresist dienen, d.h. in den nicht abgedeckten Gebieten können verschiedene Metalle galvanisch aufgebaut werden, beispielsweise Kupfer, Blei, Zink, Zinn, Nickel, Gold oder ähnliches.

Es sind eine große Anzahl solcher Substanzen bekannt, die im folgenden allgemein als "Photolacke" bezeichnet werden sollen. Beispielsweise kann es sich dabei um Filmbildner handeln, bei denen makromolekulare Substanzen in Lösungsmitteln vorliegen. Es ist auch möglich, Substanzen zu verwenden, die aus sogenannten Prepolymeren und Monomeren bestehen und die einen Photoinitiator enthalten, der bei Bestrahlung mit UV-Licht Radikale bildet. Diese Radikale wiederum führen zu einer Polymerisierung der Prepolymere und Monopolymere, so daß die Substanz durch die Bestrahlung auspolymerisiert. Beispiele solcher Photopolymere sind beispielsweise sensibilisierte Diazide oder UV-polymerisierbare Verbindungen mit Epoxydharzen, sogenannte "Probimere". Die Photopolymere können in flüssigem Zustand aufgetragen werden, es ist jedoch auch möglich, nicht flüssige Photopolymere zu verwenden, die in Form lichtempfindlicher Schichten unterschiedlicher Dicke in Folienform auf eine Leiterplatte aufgebracht werden. Es wird hierzu beispielsweise verwiesen auf die Photopolymere, die von der Firma DU PONT DE NEMOURS (Deutschland) GmbH unter der Kennzeichnung RISTON vertrieben werden. Im Rahmen der vorliegenden Anmeldung sollen alle Substanzen erfaßt werden, die durch elektromagnetische Bestrahlung ihre Natur so verändern, daß bestrahlte und nicht bestrahlte Gebiete unterschiedlich entfernbar sind.

Bei fortschreitender Miniaturisierung der Leiterplatten ergeben sich bei dieser sehr kompliziert vorbekannten Technik Schwierigkeiten. Beispielsweise tritt beim Ätzen, also bei der Entfernung des Basiskupfers in bestimmten Bereichen, unvermeidlich eine Unterätzung unter sehr schmalen Leiterbahnen auf, so daß der stehenbleibende Fuß der Leiterbahn zu dünn wird. In vielen Fällen reicht auch die Haftung und Duktilität einer Leiterbahn, beispielsweise aus Kupfer, nicht aus.

Es ist Aufgabe der Erfindung, ein Verfahren anzugeben, mit dem diese Schwierigkeiten auch bei noch stärkerer Miniaturisierung von Leiterplatten vermieden werden können.

Diese Aufgabe wird bei einem Verfahren der eingangs beschriebenen Art erfindungsgemäß dadurch gelöst, daß man den strahlungsempfindlichen Substanzen elektrisch leitende Partikel oder elektrisch leitende Salze zugibt, so daß
die nach der chemischen Entfernung auf dem Träger verbleibende Gebiete elektrisch leitend sind.

Auf diese Weise ist es möglich, elektrisch leitende Schichten in derselben Technik auf die Leiterplatte aufzubringen,
die bisher nur für Ätzresist-, Galvanoresist- oder Lötresistschichten verwendet worden ist. Es ist nicht mehr notwendig,
zusätzlich metallische Leiterschichten aufzubringen, beispielsweise galvanisch oder chemisch. Die Aufbringung und Weiterverarbeitung der elektrisch leitenden Photolacke ist mit wesentlich
größerer Präzision durchführbar als das Aufbringen metallischer
Leiterschichten, so daß auch wesentlich stärker miniaturisierte
Schaltungen noch fehlerfrei hergestellt werden können.

Vorteilhaft ist es dabei, wenn die strahlungsempfindlichen
Substanzen (Photolacke) Partikel aus Kupfer, Aluminium,
Zinn, Zink, Silber, Gold, Palladium, Titan oder Nickel
oder aus Legierungen dieser Metalle oder Salze oder Oxide
dieser Metalle enthalten.

Es ist weiterhin Aufgabe der Erfindung, einen Photolack
zur Durchführung dieses Verfahrens anzugeben. Diese Aufgabe wird bei einem Photolack der eingangs beschriebenen
Art erfindungsgemäß durch die kennzeichnenden Merkmale
des Anspruches 3 gelöst.

Die elektrisch leitenden Partikel können in Photolacken
in Form sehr fein gemahlener Pulver oder in Form von Salzen zugegeben werden, die sich in den Photolacken lösen.
Man erhält dadurch eine sehr homogene Einlagerung der
elektrisch leitenden Substanzen in den Photolacken, so
daß auch sehr dünne Photolackschichten eine gleichmäßige elektrische Leitfähigkeit zeigen. Trotzdem können diese Photolacke in der herkömmlichen Weise bereichsweise
belichtet werden, so daß sie anschließend mit herkömmlichen Verfahren (Entwickeln etc.) in bestimmten Gebieten entfernt werden können, während sie in anderen Gebieten,
die dann Leiterbahnen und Kontakte für Bohrungen in der
Leiterplatte bilden, auf dem Trägermaterial zurückbleiben.

Die nachfolgende Beschreibung bevorzugter Ausführungsformen der Erfindung dient im Zusammenhang mit der Zeichnung
der näheren Erläuterung. Es zeigen:

Figuren 1 - 5a    eine Schnittansicht einer Leiterplatte bei aufeinanderfolgenden
                  Verfahrensschritten zur Aufbringung
                  von Leiterbahnen und

Figuren 6 - 14    eine Schnittansicht einer Leiterplatte bei aufeinanderfolgenden
                  Verfahrensschritten zur Aufbrin-
                  gung durchkontaktierter Leiter-
                  bahnen.

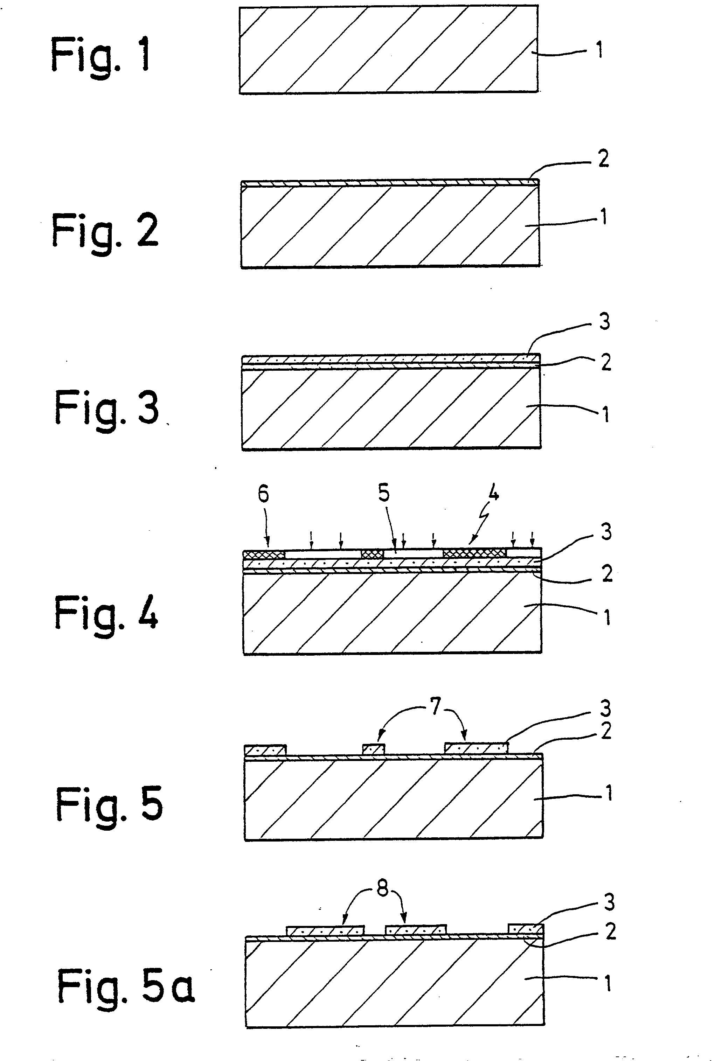

Auf dem in Figur 1 dargestellte Trägermaterial 1 einer
Leiterplatte, das beispielsweise aus Glasfaserepoxidharz,
Polyimid, Phenolharzpapier, Polytetrafluoräthylen oder
ähnlichen Substanzen bestehen kann, wird zunächst chemisch oder mechanisch die oberste Schicht 2 vorbehandelt,
insbesondere aufgerauht, so daß an dieser Schicht 2 ein
Photolack haften kann. In einem nächsten Verfahrensschritt
(Figur 3) wird auf diese Haftschicht 2 eine Photolackschicht aufgebracht, wobei diese Photolackschicht erfindungsgemäß elektrisch leitend ausgebildet ist. Auf diese
Photolackschicht 3 wird eine Maske 4 aufgelegt, die lichtdurchlässige Bereiche 5 und lichtundurchlässige Bereiche
6 nebeneinander aufweist. Diese Maske kann beispielsweise
ein Diapositiv sein. Durch diese Maske hindurch wird in
der in Figur 4 durch die Pfeile  angedeuteten Weise die
Photolackschicht 3 belichtet, beispielweise mit sichtbarem Licht oder mit UV-Licht, je nach Natur des verwendeten Photolackes. In einem weiteren Verfahrensschritt werden Teilbereiche des Photolackes wieder von der Leiterplatte entfernt, beispielsweise durch Entwickeln. Wenn Photolacke verwendet werden, die durch Bestrahlung in einen
Zustand überführt werden, in dem sie durch die nachfolgende chemische Behandlung entfernt werden können, bleiben nach einer solchen chemischen Behandlung die unbestrahlten Bereiche 7 auf der Leiterplatte zurück (Figur
5), bei Photolacken, bei denen bestrahlte Bereiche durch
die chemische Behandlung nicht mehr entfernt werden können, bleiben bestrahlte Bereiche 8 auf der Leiterplatte
zurück (Figur 5a). Die auf der Leiterplatte verbleibenden
Bereiche 7 bzw. 8 sind gemäß der Erfindung elektrisch leitfähig, d.h. diese Bereiche können unmittelbar als Leiterbahnen eingesetzt werden, ohne daß eine nachfolgende Behandlung notwendig wäre, bei welcher metallische Leiterbahnen chemisch oder galvanisch aufgebracht werden. Man erhält also eine ganz erhebliche Vereinfachung der Herstellung gedruckter Schaltungen durch dieses Verfahren und kann außerdem auch besonders feine Konturen auf diese Weise herstellen.

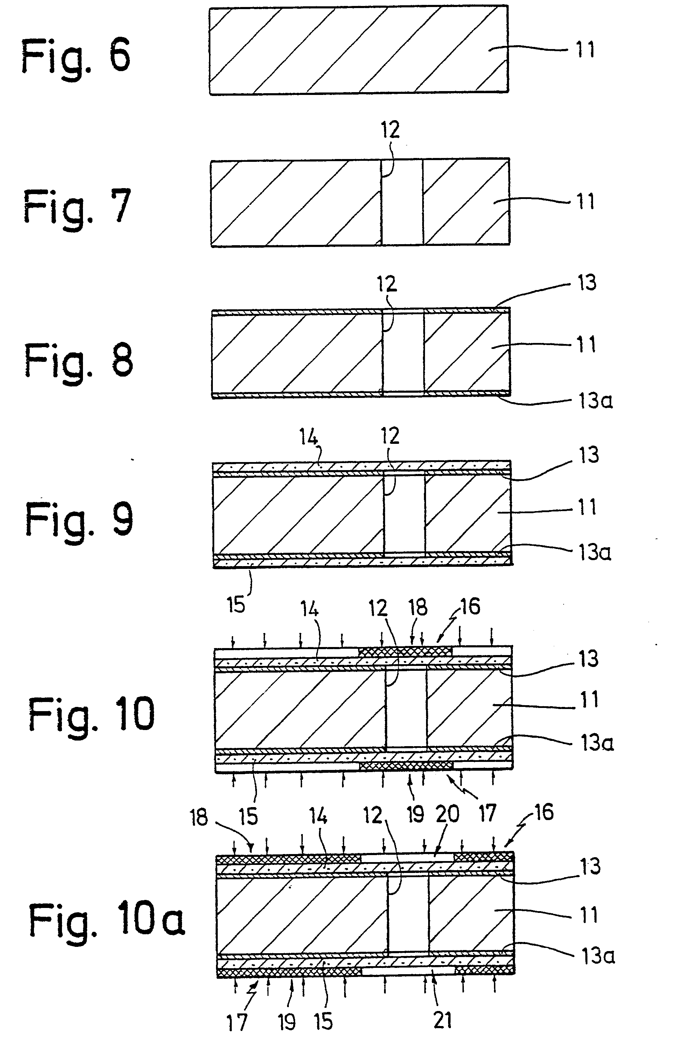

Das in Figur 6 dargestellte Trägermaterial 11 entspricht dem der Figur 1. In einem ersten Verfahrensschritt werden in dieses Trägermaterial durchgehende Bohrungen 12 eingebracht. Auf beiden Seiten wird dann das Trägermaterial 11 chemisch oder mechanisch so behandelt, daß Haftschichten 13 bzw. 13a entstehen. Diese werden in der gleichen Weise wie oben beschrieben beide mit einer elektrisch leitenden Photolackschicht 14 bzw. 15 versehen (Figur 9).

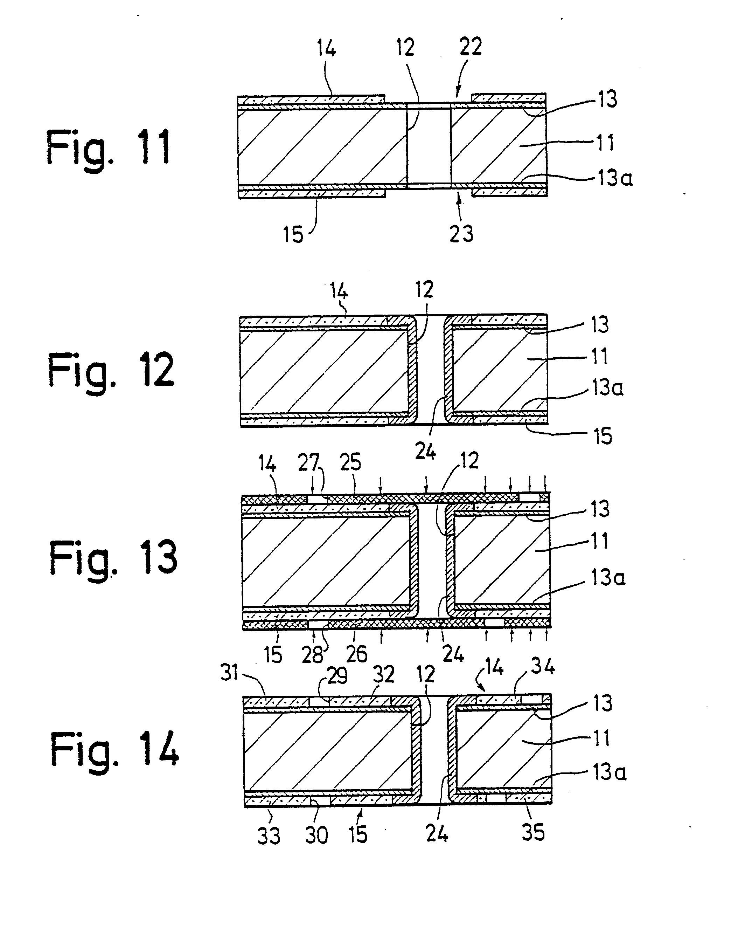

Anschließend werden auf beiden Seiten Masken 16 bzw. 17 aufgelegt, die beispielsweise im Bereich der Bohrungen 12 lichtundurchlässige Bereiche 18 und 19 (Figur 10) oder umgekehrt lichtdurchlässige Bereiche 20 bzw. 21 (Figur 10a) aufweisen, deren Durchmesser etwas größer ist als der der Bohrung 12. Masken mit lichtundurchlässigen Bereichen (Figur 10) werden dort verwendet, wo unbelichtetes Photolackmaterial nachfolgend entfernbar ist, während Masken mit lichtdurchlässigen Bereichen (Figur 10a) verwendet werden, wenn Photolacke eingesetzt werden, die nach Belichtung entfernbar sind. Nach der Belichtung und der Entfernung der entsprechend modifizierten Photolackbereiche erhält
man im Bereich der Bohrungen 12 von Photolackschichten 14
und 15 freie Bereiche 22 bzw. 23 (Figur 11).

In einem nächsten Verfahrensschritt wird die Leiterplatte
chemisch mit einer Kupferschicht 24 versehen, die nur die von
den Photolackschichten 14 und 15 freien Bereiche der Leiterplatte bedeckt, also im wesentlichen die freien Bereiche 22
und 23 und die Innenwände der Bohrung 12 (Figur 12). Auf diese Weise ist es möglich, eine elektrisch leitende Verbindung
von der Photolackschicht 14 auf der Oberseite der Platte durch
die Bohrung 12 hindurch zu der Photolackschicht 15 auf der Unterseite der Platte herzustellen. Es ist dabei möglich, daß
sich zwischen den beiden Photolackschichten 14 und 15 und der
angrenzenden Kupferschicht 24 keine enge Verbindung ergibt,
da die Photolackschichten als Galvanoresiste wirken und daher
die Anlagerung von Kupfer erschweren. Trotzdem läßt sich in
der Praxis eine gute elektrische Verbindung zwischen den Photolackschichten und der Kupferschicht herstellen, wenn die
Leiterplatten in einem späteren Verfahrensschritt - wie dies
allgemein üblich ist - in einem Zinnbad heißverzinnt werden.
Das Zinn bedeckt dann die Kupferschichten und füllt alle
Spalte zwischen den Kupferschichten und den Photolackschichten
aus. Dadurch wird ein einwandfreier elektrischer Übergang
von den Photolackschichten in die Kupferschicht 24 gewährleistet.

Um die Photolackschichten 14 und 15 der Leiterplatte zusätzlich in einzelne Leiterbahnen zu unterteilen, werden in einem
weiteren Verfahrensschritt erneut Masken 25 und 26 auf die
Ober- bzw. Unterseite der Leiterplatte aufgelegt, die lichtdurchlässige Bereiche 27 bzw. 28 aufweisen (Figur 13). Nach
einer Belichtung ist es möglich, die unterhalb der lichtdurchlässigen Bereiche 27 und 28 liegenden Bereiche 29
und 30 der Photolackschichten 14 und 15 durch Entwickeln
zu entfernen, so daß sowohl auf der Oberseite als auch auf
der Unterseite der Leiterplatte elektrisch voneinander getrennte Leiterbahnen 31, 32, 33, 34, 35 ausgebildet werden;
die die Bohrung 12 umgebenden Leiterbahnen 32 auf der Ober-
und Unterseite der Leiterplatte sind über die Kupferschicht
24 elektrisch miteinander verbunden (Figur 14).

In allen Fällen kann die Photolackschicht in herkömmlicher
Weise aufgetragen werden, beispielsweise durch Auflaminieren,
Aufsprühen, Aufwalzen oder Aufgießen, die Entfernung bestimmter Bereiche der Photolackschicht nach der Belichtung kann
ebenfalls in herkömmlicher Weise erfolgen, beispielsweise
durch Lösungsmittel oder durch Entwicklung.

Die beschriebene Art der Leiterplattenherstellung hat den
Vorteil, daß bei den bekannten Verfahren mögliche Fehler
durch Verzug des Polymers auf einer Kupferschicht, Beschichtungsfehler, Entwicklungsfehler oder das Auftreten von
Ätz- oder Galvanofehlern wegfallen. Das zu erzeugende Leiterbild kann unmittelbar durch den Photolack auf der Leiterplatte erzeugt werden, wodurch eine wesentlich größere Präzision
ermöglicht wird.

0130615

A 45 556 u
u – 183
3. Mai 1983

Anmelderin: Firma
Gebr. Schmid GmbH & Co.

7290 Freudenstadt

P a t e n t a n s p r ü c h e :

1. Verfahren zur Herstellung gedruckter Schaltungen, bei
   welchem man auf einen Träger Substanzen aufbringt, die
   sich durch elektromagnetische Strahlung so verändern,
   daß bestrahlte Gebiete nach der Bestrahlung chemisch
   entfernbar sind, während unbestrahlte Gebiete auf dem
   Träger verbleiben oder umgekehrt,
   d a d u r c h   g e k e n n z e i c h n e t , daß man
   den strahlungsempfindlichen Substanzen elektrisch leitende Partikel oder elektrisch leitende Salze zugibt,
   so daß die nach der chemischen Entfernung auf dem Träger verbleibenden Gebiete elektrisch leitend sind.

2. Verfahren nach Anspruch 1, dadurch gekennzeichnet, daß
   man den strahlungsempfindlichen Substanzen Partikel aus
   Kupfer, Aluminium, Zinn, Zink, Silber, Gold, Palladium,
   Titan oder Nickel oder aus Legierungen dieser Metalle

0130615

oder Salze oder Oxide dieser Metalle zugibt.

3. Photopolymer zur Herstellung gedruckter Schaltungen,
   d a d u r c h   g e k e n n z e i c h n e t ,  daß
   er elektrisch leitfähige Partikel oder Salze enthält.

4. Photopolymer nach Anspruch 3, dadurch gekennzeichnet,
   daß er Partikel aus Kupfer, Aluminium, Zinn, Zink, Silber, Gold, Palladium, Titan oder Nickel oder aus Legierungen dieser Metalle oder Salze oder Oxide dieser
   Metalle enthält.

------------------------

-113-

0130615

Fig. 1

Fig. 2

Fig. 3

Fig. 4

Fig. 5

Fig. 5a

M 04·07·84

0130615

Fig. 6

Fig. 7

Fig. 8

Fig. 9

Fig. 10

Fig. 10a

Fig. 11

Fig. 12

Fig. 13

Fig. 14